(19) **Europäisches Patentamt**

**European Patent Office**

**Office européen des brevets**

(11) **EP 1 368 667 B1**

(12) **EUROPÄISCHE PATENTSCHRIFT**

(45) Veröffentlichungstag und Bekanntmachung des Hinweises auf die Patenterteilung:
**05.01.2005 Patentblatt 2005/01**

(21) Anmeldenummer: 02724238.7

(22) Anmeldetag: **15.03.2002**

(51) Int Cl.$^7$: **G01R 15/24**

(86) Internationale Anmeldenummer:
**PCT/EP2002/002906**

(87) Internationale Veröffentlichungsnummer:
**WO 2002/075249 (26.09.2002 Gazette 2002/39)**

(54) **VERFAHREN UND EINRICHTUNG ZUR STROMMESSUNG MITTELS EINES FASEROPTISCHEN IN-LINE-SAGNAC-INTERFEROMETERS UND DAFÜR GEEIGNETER PHASENMODULATOR**

METHOD AND DEVICE FOR CURRENT MEASUREMENT BY MEANS OF FIBRE-OPTIC IN-LINE SAGNAC INTERFEROMETER AND PHASE MODULATOR SUITABLE FOR THE ABOVE

PROCEDE ET DISPOSITIF DE MESURE DE COURANT AU MOYEN D'UN INTERFEROMETRE DE SAGNAC EN LIGNE A FIBRES OPTIQUES ET MODULATEUR DE PHASE APPROPRIE

(84) Benannte Vertragsstaaten:
**CH FR LI**

(30) Priorität: **16.03.2001 DE 10112835**

(43) Veröffentlichungstag der Anmeldung:
**10.12.2003 Patentblatt 2003/50**

(73) Patentinhaber: **LITEF GmbH**
**79115 Freiburg (DE)**

(72) Erfinder:
• **VOIGT, Sven**
**79111 Freiburg (DE)**

• **SPAHLINGER, Günter**
**70188 Stuttgart (DE)**

(74) Vertreter: **Müller - Hoffmann & Partner Patentanwälte,**
**Innere Wiener Strasse 17**
**81667 München (DE)**

(56) Entgegenhaltungen:
WO-A-98/03895          DE-A- 19 808 517
US-A- 5 485 274          US-A- 5 644 397
US-B1- 6 301 400

EP 1 368 667 B1

**Beschreibung**

Die Erfindung betrifft ein Verfahren und eine Einrichtung zur Strommessung mittels eines faseroptischen In-Line-Sagnac-Interferometers, sowie einen dazu geeigneten Phasenmodulator.

In den kommenden Jahren sollen optische Strommesseinrichtungen zunehmend konventionelle Strommesseinrichtungen ablösen. Eine technologisch bereits erprobte Variante einer optischen Strommesseinrichtung ist auf Basis eines In-Line Sagnac-Interferometers realisiert, was eine physikalisch sowie technologisch elegante Lösung ist.

Ein derartiger Stromsensor misst den durch einen Stromleiter fließenden elektrischen Strom mittels des Faraday-Effekts. Unter diesem Effekt versteht man die Tatsache, dass bei der Ausbreitung von linear polarisiertem Licht parallel zu den Feldlinien eines magnetischen Felds die Licht-Schwingungsebene gedreht wird. Damit lässt sich unter Ausnutzung dieses Effekts eine Phasenverschiebung zwischen zwei orthogonalen Polarisationsmoden eines das In-Line-Sagnac-Interferometer durchsetzenden Lichtstrahls erzeugen, wenn die Polarisationsmoden in einer von dem Stromleiter durchsetzten optischen Messspule geführt werden. Die durch den elektrischen Strom bewirkte Phasenverschiebung zwischen den Polarisationsmoden ist damit ein Maß für die zu messende Stromstärke und kann durch Auswertung eines Interferenzmusters gemessen werden, das durch Interferieren der beiden gegeneinander verschobenen Polarisationsmoden erzeugt wird.

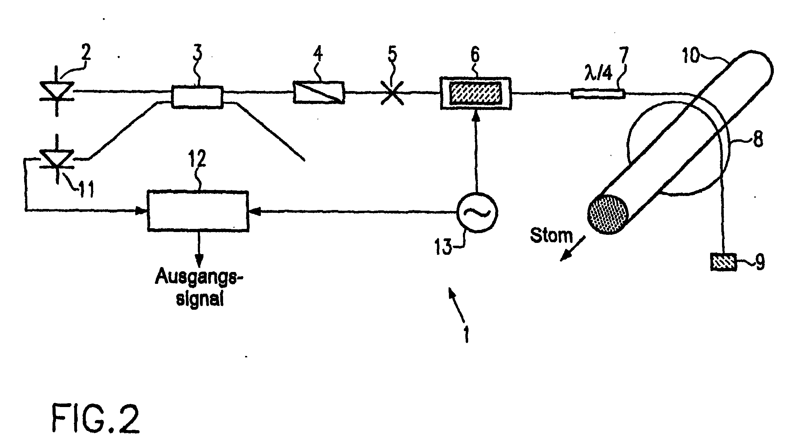

Im Folgenden wird unter Zuhilfenahme von Fig. 2 ein Ausführungsbeispiel eines auf einem In-Line-Sagnac-Interferometer basierenden Stromsensors, wie er in der Veröffentlichung Blake/Tantaswadi/Carvalho: "In-Line Sagnac-Interferometer for Magnetic Field Sensing", Proc. SPIE, 2360, 419-422. (1994) beschrieben ist, sowie dessen Funktionsweise näher erläutert.

Ein Stromsensor 1 unter Verwendung eines In-Line Sagnac-Interferometers weist eine Lichtquelle 2, einen Koppler 3, einen Polarisator 4, einen 45° Spleiß 5, einen Doppelbrechungs-Phasenmodulator 6, einen λ/4-Phasenschieber 7, eine als Strommessspule dienende isotrope Faserspule 8, einen Reflektor 9, einen Stromleiter 10, einen Detektor 11, eine Verstärkungs/ Auswertungseinheit 12, und eine Phasenmodulator-Ansteuereinheit 13 auf.

Das von der Lichtquelle 2 über den Koppler 3 erhaltene Licht wird durch den Polarisator 4 polarisiert und mittels des Spleisses 5 unter 45° gegen die Polarisationsachsen einer polarisationserhaltenden, doppelbrechenden Faser der Faserspule 8 eingekoppelt, so dass in der gleichen Faser parallel zwei verschiedene Porarisationsmoden mit annähernd gleicher Amplitude geführt werden. Die bei einem herkömmlichen Sagnac-Interferometer übliche Aufspaltung eines das Interferometer durchsetzenden Lichtstrahls in zwei gegenläufige Licht-Teilstrahlen wird beim In-Line Sagnac-Interferometer also ersetzt durch "Zerlegung" des Lichtstrahls in zwei parallel geführte Polarisationsmoden (darunter werden parallel geführte "Teil-Lichtstrahlen" eines Primärlichtstrahls mit einer definierten Polarisation verstanden), die aufgrund der polarisationserhaltenden Faser jeweils effektiv einen anderen optischen Lichtweg benutzen. Beide Polarisationsmoden durchlaufen den vorzugsweise als Pockels-Zelle realisierten Doppelbrechungs-Phasenmodulator 6 zur Erzeugung einer nichtreziproken Phasenverschiebung zwischen den Polarisationsmoden, den λ/4-Phasenschieber 7 zur Konversion von linear polarisiertem Licht in zirkular polarisiertes Licht (zur Erzielung maximaler Wirkung des Faraday-Effekts) und die isotrope Faserspule 8, die von einem Stromleiter 10 durchsetzt ist, zu dem Reflektor 9, der bei Reflexion die Polarisation der auftreffenden Polarisationsmoden um 90° dreht und damit die Polarisation der beiden Polarisationsmoden vertauscht. Fließt in dem Stromleiter 10 ein Strom, so wird zwischen den beiden zirkular polarisierten Polarisationsmoden aufgrund des Faraday-Effekts eine Phasenverschiebung erzeugt. Beide Polarisationsmoden laufen den gleichen Lichtweg wieder zurück, weisen jedoch hierbei die jeweils andere Polarisation auf. Die zurückgelaufenen Polarisationsmoden werden am Spleiss 5 zusammengeführt und über den Polarisator 4 und den Koppler 3 einem Detektor 11 als Interferenz-Lichtstrahl zugeführt.

Ein wesentlicher Vorteil des so erhaltenen Aufbaus eines zu einem In-Line-Sagnac-Interferometer modifizierten herkömmlichen Sagnac-Interferometers hat den Vorteil eines streng reziproken Verhaltens. Das heißt, dass ohne Stromfluß im Stromleiter 10 die beiden Polarisationsmoden beim Auskoppeln aus der polarisationserhaltenden Faser der Faserspule 8 dieselbe Phasenverschiebung gegeneinander aufweisen, die sie beim Einkoppeln in die polarisationserhaltende Faser aufwiesen. Phasenverschiebungen zwischen den beiden Polarisationen, die aufgrund räumlicher Bewegungen des Interferometers, durch Temperaturgradienten oder durch mechanische Spannungen im Fasermaterial entstehen, sind aufgrund der parallelen Führung der Polarisationsmoden reziproke Effekte, die sich kompensieren. Der einzige maßgebliche Effekt, der eine nichtreziproke Phasenverschiebung zwischen den das Interferometer durchsetzenden orthogonalen Polarisationsmoden bewirkt, ist der Faraday-Effekt.

Zusätzlich ist jedoch, wie erwähnt, mittels des Doppelbrechungs-Phasenmodulators 6 die Erzeugung einer nichtreziproken Phasenverschiebung zwischen den Polarisationsmoden möglich, was zur Verschiebung einer Interferometer-Kennlinie in einen Bereich höchster Linearität benutzt wird. Der Doppelbrechungs-Phasenmodulator 6 wirkt polarisationserhaltend, also nicht polarisierend auf die Polarisationsmoden, d. h. beide Polarisationsmoden werden gleichberechtigt im Doppelbrechungs-Phasenmodulator 6 geführt, aber unter Ausnutzung des Pockels-Effekts der Polariation entsprechend jeweils unterschiedlich moduliert.

Dazu ist der Wellenleiter im Phasenmodulator 6 als anisotropischer elektrooptischer Kristall ausgebildet, womit der Pockels-Effekt richtungsabhängig wird und sich als Tensor darstellen läßt. Die unterschiedliche Wirkung des durch den Doppelbrechungs-Phasenmodulator 6 erzeugten elektromagnetischen Felds auf die unterschiedlichen Polarisationen kommt mathematisch dadurch zum Ausdruck, dass der jeweilige Einfluss durch unterschiedliche Tensorelemente beschreibbar ist: Der effektive Brechungsindex für unterschiedliche Polarisationsmoden wird durch das elektromagnetische Feld unterschiedlich stark geändert, was in einer Phasenverschiebung zwischen den Polarisationsmoden resultiert. Ein Doppelbrechungs-Phasenmodulator mit oben genannten Eigenschaften ist beispielsweise durch eine auf eine Piezokeramik aufgewickelte polarisationserhaltende Faser realisierbar. Der Doppelbrechungs-Phasenmodulator wird von der Phasenmodulator-Ansteuereinheit 13 mit einem Modulationssignal beaufschlagt.

Die Phasenverschiebung zwischen den Polarisationsmoden wird durch den Detektor 11 gemessen, dessen Ausgangssignal einer Verstärkungs/Auswertungseinheit 12 zugeführt wird.

Ein weiteres Beispiel eines Stromsensors auf Basis eines In-Line-Sagnac-Interferometers findet sich in der Veröffentlichung Frosio/Dänndliker: "Reciprocal reflection interferometer for a fiber-optic Faraday current sensor", in APPLIED OPTICS/1. September 1994/Vol. 33. No. 25. Der Aufbau des darin beschriebenen In-Line-Sagnac-Interferometers ist dem oben beschriebenen Aufbau sehr ähnlich. Störungen aufgrund von Doppelbrechung in der polarisationserhaltenden Faser werden mit Hilfe einer Lichtquelle, die kurzkohärentes Licht aussendet, vermieden.

Ein weiteres Beispiel eines Stromsensors findet sich in Offenlegungsschrift DE 198 08 517 A1. Dieser Stromsensor basiert auf einem herkömmlichen Sagnac-Interferometer. Damit ist der wesentliche Unterschied zu den vorherigen Ausführungsformen der, dass die Phasenverschiebung zwischen zwei gegenläufigen, durch Strahlteilung entstandenen Licht-Teilstrahlen erzeugt wird. Dies bedeutet jedoch, dass die verwendete Faserspule (Strommessspule) nicht isotrop ist, was den Stromsensor anfällig gegenüber Störeffekten aufgrund von Drehungen macht,

In der Patentanmeldung DE 100 44 197.1 ist ein auf einem In-Line-Sagnac-Interferometer basierender Spannungssensor beschrieben, der einen ähnlichen Aufbau wie der obige Stromsensor aufweist. Auch hier wird eine Phasenverschiebung zwischen zwei Polarisationsmoden erzeugt, die jedoch nicht mittels des Faraday-Effekts, sondern über eine an einem zusätzlichen Phasenmodulator anliegende Spannung bewirkt wird.

Dokument US-A-5,644,397 offenbart einen Sensor, in dem eine polarisationserhaltende optische Faser eingesetzt wird, die entweder einen schleifenförmigen oder einen linearen optischen Pfad bildet. Zirkular polarisiertes Licht propagiert entlang des optischen Pfads und passiert ein feldsensitives Abtastmedium. Eine Phasenverschiebung, die in den Lichtquellen durch ein magnetisches Feld induziert wird, wird durch einen Fotodetektor bzw. zugehöriger Signalverarbeitungs-Elektronik detektiert.

Dokument US-A-5,485,274 offenbart ein Sagnac-Interferometer, in dem ein integrierter optischer Chip (MIOC) als Michelson-Interferometer eingesetzt wird, um die Wellenlänge der Lichtquelle des Interferometers zu stabilisieren. Dies wird dadurch erreicht, dass ein statisch unabhängiges Signal auf ein Rückstellsignal, das proportional der Drehrate ist, aufaddiert wird.

Dokument US-A-6,301,400 B1 offenbart einen optischen Sensor, der gegenüber Umwelteinflüssen wie Temperatur und Vibration weitgehend unabhängig ist.

In Dokument Shayne X. Short "Elimination of Birefringence in used Scale Factor Errors in the In-line-Sagnac-Interferometer Current Sensor". Journal of Lightwave Technology, Vol. 16, No.10, Oktober 1998, ist ein Verfahren zur Strommessung mittels eines faseroptischen In-line-Sagnac-Interferometers beschrieben, bei dem zwischen zwei orthogonalen Polarisationsmoden eines das Interferometer durchsetzenden Lichtsstrahls durch einen zu messenden Strom eine erste nichtreziproke Phasenverschiebung erzeugt wird, und zur Ermittlung der ersten Phasenverschiebung die Phasen der Polarisationsmoden unter Ausnutzung des Pokkels-Effekts durch eine zweite nichtreziproke Phasenverschiebung zusätzlich geändert werden, derart, dass durch die zweite Phasenverschiebung eine Kompensation der ersten Phasenverschiebung bewirkt wird.

Der Erfindung liegt die Aufgabe zugrunde, eine Einrichtung zur faseroptischen Strommessung anzugeben, die gegenüber dem Stand der Technik konstruktive Vereinfachungen bzw. eine erhöhte Messgenauigkeit aufweist.

Die angegebene Aufgabe wird erfindungsgemäß bei einem Verfahren zur faseroptischen Strommessung gemäß Anspruch 1 gelöst. Desweiteren stellt die Erfindung eine Einrichtung zur faseroptischen Strommessung gemäß Anspruch 3 bereit. Weitere vorteilhafte Ausgestaltungen und Weiterbildungen des Erfindungsgedankens sind in der nachfolgenden Beschreibung näher erläutert und/oder in abhängigen Patentansprüchen definiert.

Bei dem erfindungsgemäßen Verfahren zur Strommessung mittels eines faseroptischen In-Line-Sagnac-Interferometers, bei dem zwischen zwei orthogonalen Polarisationsmoden eines das Interferometer durchsetzenden Lichtstrahls durch einen zu messenden Strom eine erste nichtreziproke Phasenverschiebung erzeugt wird, wobei zur Ermittlung der ersten Phasenverschiebung die Phasen der Polarisationsmoden unter Ausnutzung des Pockels-Effekts durch eine zweite nichtreziproke Phasenverschiebung zusätzlich geändert werden, derart, dass durch die zweite Phasenverschiebung eine Kompensation der ersten Phasenverschiebung bewirkt wird, erfoigt die zweite Phasenverschiebung durch eine Mehrzahl binär abgestufter elektromagnetischer Felder, durch die die Polarisationsmoden geführt werden, wobei die zweite Phasenverschiebung eine Verschiebung der Kennlinie des Interferometers in einen Bereich maximaler Linearität umfasst, und wobei die Feldstärken der einzelnen elektromagnetischen Felder so variiert werden, dass die Kennlinie des Interferometers stochastisch unabhängig um +/- 1.5 π oder um +/- 0.5 π in ihrer Phase verschoben wird.

Die erfindungsgemäße Einrichtung zur Strommessung mittels eines faseroptischen In-Line-Sagnac-Interferometers, das einen Doppelbrechungs-Phasenmodulator zur nichtreziproken Phasenmodulation zweier orthogonaler Polarisationsmoden eines das Interferometer durchsetzenden Lichtstrahls aufweist und als Closed-Loop-System ausgeführt ist, zeichnet sich dadurch aus, dass der Doppelbrechungs-Phasenmodulator ein digitaler Doppelbrechungs-Phasenmodulator mit binär abgestuften Elektroden ist, über den eine durch einen zu messenden Strom bewirkte Phasenverschiebung zwischen den Polarisationsmoden kompensierbar ist, wobei die Elektroden von einem Zufallsgenerator ansteuerbar sind, der digitale Modulations-Signale zur statistisch unabhängigen Verschiebung der Interferometerkennlinie um +/- 1,5 π oder um +/- 0.5 π in ihrer Phase erzeugt.

Ein wesentlicher Aspekt der Erfindung ist, dass der Phasenmodulator der erfindungsgemäßen, auf Basis eines In-Line-Sagnac-Interferometers realisierten Einrichtung zur faseroptischen Strommessung (welche im Folgenden als Stromsensor bezeichnet wird), ein digitaler Doppelbrechungs-Phasenmodulator (im Folgenden als Phasenmodulator bezeichnet) ist. Der Phasenmodulator erzeugt eine Mehrzahl elektromagnetischer Felder, die von orthogonalen Polarisationsmoden eines das Interferometer durchsetzenden Lichtstrahls durchlaufen werden, womit aufgrund des Pockels-Effekts eine nichtreziproke Phasenmodulation zwischen den Polarisationsmoden entsteht.

Die Verwendung eines digitalen Phasenmodulators ermöglicht es, auf einen Digital/Analog-Umwandler, der bei Verwendung eines analogen Phasenmodulators als "Bindeglied" zwischen einer eventuellen digitalen Phasenmodulator-Ansteuereinrichtung und dem analogen Phasenmodulator notwendig ist, zu verzichten. Damit kann der hohe Leistungsverbrauch eines Digital/Analog-Umwandlers umgangen, und bereits vorhandene digitale Signalverarbeitungs- und Steuerelektronik, beispielsweise die eines herkömmlichen Sagnac-Interferometers, ohne wesentliche Änderungen auch bei einem Stromsensor verwendet werden.

Insbesondere die Verwendung von binär abgestuften elektromagnetischen Feldern bzw. Elektroden ermöglicht konstruktive Vereinfachungen von Signalverarbeitungs- bzw. Phasenmodulator-Steuereinrichtungen des Stromsensors, da in diesem Fall eine enge Korrelation zwischen einem als Binär-Zahl interpretierbaren, parallel erzeugten Satz von digitalen Modulationssignalen und der Größe der dadurch bewirkbaren Phasenverschiebung besteht, womit ein direktes Anlegen des digitalen Modulationssignal-Satzes an die Elektroden sinnvoll ist.

Wesentlich ist weiterhin, dass die Ermittlung der durch den zu messenden Strom bewirkten Phasenverschiebung durch Rückstellung dieser erfolgt. Damit dient der Phasenmodulator in erster Linie der Kompensation der durch den zu messenden Strom bewirkten Phasenverschiebung zwischen den orthogonalen Polarisationsmoden (Closed-Loop-System). Die Messung der Phasenverschiebung durch Kompensation ermöglicht eine hohe Messgenauigkeit sowie ein problemloses Ermitteln "großer" Phasenverschiebungen.

Zur Erhöhung der Meßgenauigkeit wird der Phasenmodulator zum stochastisch unabhängigen Verschieben der Kennlinie des Interferometers um +/- 1,5 π oder um +/- 0.5 π in ihrer Phase genutzt, womit die Kennlinie in einen Bereich maximaler Linearität verschoben wird.

Zwischen den zweckmäßigerweise zu Elektrodenpaaren binär abgestufter Längen zusammengefassten Elektroden (d. h. die Längen der Elektrodenpaare bilden eine Binärsequenz) des Phasenmodulators verläuft ein Integriertoptischer, doppelbrechender Wellenleiter zum gleichberechtigten Führen zweier orthogonaler Polarisationsmoden. Die Elektroden sind vorzugsweise in konstantem gegenseitigen Abstand von der optischen Achse des Wellenleiters angeordnet, der beispielsweise durch Eindiffusion von Titan in einen $LiNbO_3$-Kristall hergestellt ist. Die an die jeweiligen Elektrodenpaare angelegten Spannungen zur Erzeugung der elektromagnetischen Felder werden unabhängig voneinander variiert (hier wird unter "Variation" das Umschalten zwischen diskreten Werten verstanden). Damit lassen sich jeweils "getrennte" Phasenverschiebungen der den Stromsensor durchsetzenden Polarisationsmoden bewirken. Die einzelnen elektromagnetischen Felder können als "Grundbausteine" eines "digitalen" elektromagnetischen Gesamtfeldes angesehen werden. Im Vergleich zu einem herkömmlichen analogen Doppelbrechungsphasenschieber mit einem einzigen Modulationselektrodenpaar ist also wenigstens eine dessen Modulationselektroden ersetzt durch eine Mehrzahl von Elektroden mit vorzugsweise binär abgestuften Längen. Vorzugsweise beträgt die Anzahl der Elektrodenpaare acht

Die Elektroden binär abgestufter Längen können auch so angeordnet sein, dass einer langen Elektrode mehrere kurze Elektroden gegenüberliegen. wobei die Kombination einer langen Elektrode mit einer kurzen Elektrode jeweils ein "Elektrodenpaar" bildet. Der Wellenleiter des Phasenmodulators verläuft in dieser Ausführungsform zwischen der langen Elektrode und den kurzen, binär abgestuften Elektroden.

Die Erfindung und vorteilhafte Einzelheiten werden nachfolgend unter Bezug auf die Zeichnungen in beispielsweiser Ausführungsform näher erläutert. Es zeigen:

**Fig. 1** eine bevorzugte Ausführungsform eines erfindungsgemäßen Stromsensors auf Basis eines In-Line Sagnac-Interferometers;

**Fig. 2** einen herkömmlichen Stromsensor auf Basis eines In-Line Sagnac-Interferometers;

**Fig. 3** eine bevorzugte Ausführungsform eines erfindungsgemäßen Phasenmodulators.

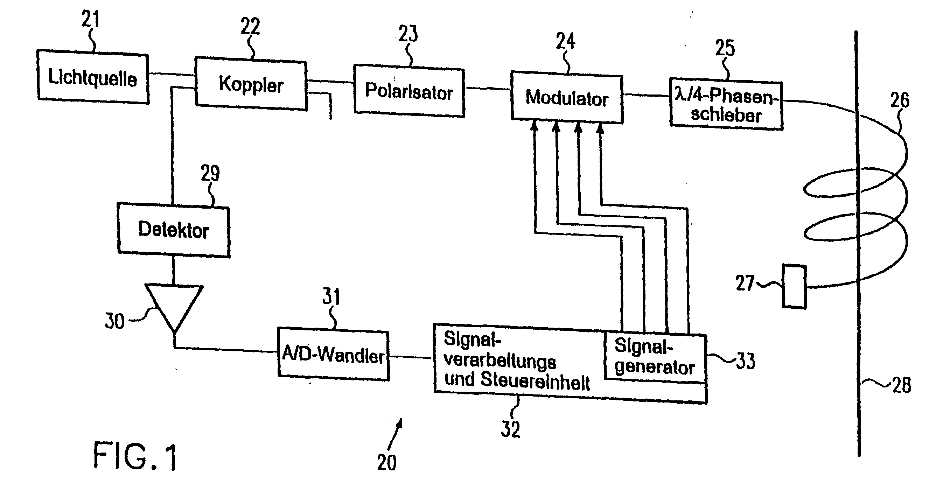

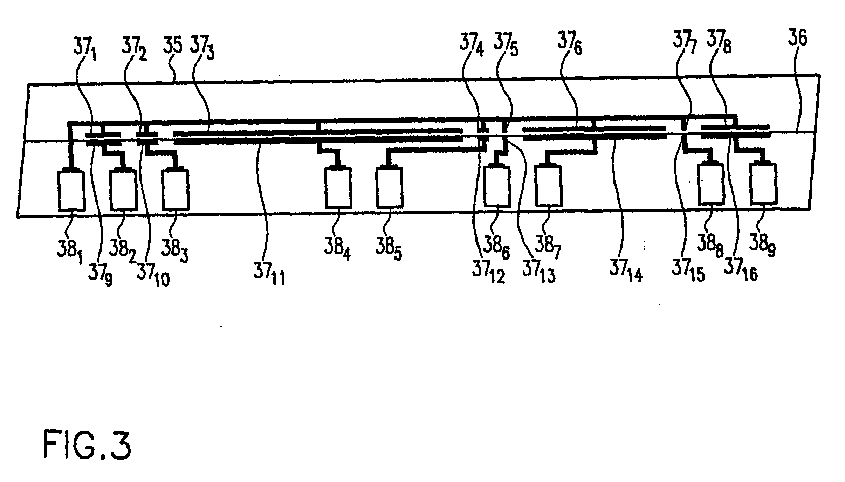

In der folgenden Beschreibung wird unter Bezugnahme auf Fig. 1 und Fig. 3 eine bevorzugte Ausführungsform eines Stromsensors auf Basis eines In-Line-Sagnac-Interferometers beschrieben.

Ein Stromsensor 20 auf Basis eines In-Line-Sagnac-Interferometers weist eine Lichtquelle 21, einen Koppler 22, einen Polarisator 23, einen Doppelbrechungs-Phasenmodulator 24, einen $\lambda/4$-Phasenschieber 25, eine isotrope Faserspule 26, einen Reflektor 27, einen Stromleiter 28, einen Detektor 29, einen Verstärker 30, einen Analog/Digital-Umwandler 3 1, eine Signalverarbeitungs- und Steuereinheit 32, sowie eine in der Signalverarbeitungs- und Steuereinheit 32 integrierten Signalgeneratoreinheit 33 auf.

Wesentlicher Unterschied zum in Fig. 2 gezeigten Stromsensor ist, dass der Phasenmodulator 24 als digitaler Doppelbrechungs-Phasenmodulator mit binär abgestuften Elektroden realisiert ist, dessen Ansteuerung vorzugsweise direkt aus digitalen Komponenten in der Signalverarbeitungs- und Steuereinheit 32 bzw. der Signalgeneratoreinheit 33 heraus erfolgt.

Das von der Lichtquelle 21 über den Koppler 22 erhaltene Licht wird durch den Polarisator 23 polarisiert und unter 45° gegen die Polarisationsachsen einer polarisationserhaltenden, doppelbrechenden Faser der Faserspule 26 eingekoppelt, so dass in der gleichen Faser parallel zwei verschiedene Porarisationsmoden mit annähernd gleicher Stärke geführt werden. Beide Polarisationsmoden durchlaufen den Phasenmodulator 24 zur Erzeugung einer nichtreziproken Phasenverschiebung zwischen den Polarisationsmoden, den $\lambda/4$-Phasenschieber 25 zur Konversion von linear polarisiertem Licht in zirkular polarisiertes Licht und die isotrope Faserspule 26, die von dem Stromleiter 28 durchsetzt ist, zu dem Reflektor 27, der bei Reflexion die Polarisation der auftreffenden Polarisationsmoden um 90° dreht und damit die Polarisation der beiden Polarisationsmoden vertauscht. Fließt in dem Stromleiter 28 ein Strom, so wird zwischen den beiden zirkular polarisierten Polarisationsmoden aufgrund des Faraday-Effekts eine Phasenverschiebung erzeugt. Beide Polarisationsmoden laufen den gleichen Lichtweg wieder zurück, interferieren im Polarisator 23 und werden über den Koppler 22, einem Detektor 29 als Interferenz-Lichtstrahl zugeführt. Ein analoges Ausgangssignal des Detektors 29 wird durch den Verstärker 30 angehoben und über den Analog/Digital-Wandler 31 der Signalverarbeitungs- und Steuereinheit 32 zugeführt, die das digitale Signal auswertet. In Abhängigkeit des digitalen Signals erzeugt die Signalgeneratoreinheit 33 ein direkt den Phasenmodulator beaufschlagendes digitales Kompensationssignal für die durch den zu messenden Strom bewirkten Phasenverschiebung. Vorzugsweise wird das Kompensationssignal mit einem Signal zur stochastisch unabhängigen Verschiebung der Interferometerkennlinie um +/- $1,5\,\pi$ oder um +/- $0,5\,\pi$ in den Bereich höchster Linearität überlagert.

Der im oben beschriebenen Aufbau verwendete Phasenmodulator 24 hat vorzugsweise die in Fig. 3 gezeigte Ausgestaltung, welche im Folgenden näher erläutert wird.

Der Phasenmodulator 24 ist als integriert-optisches Bauelement auf der Basis eines LiNbO$_3$-Kristalls 35 ausgebildet. Durch den LiNbO$_3$-Kristall 35 verläuft ein polarisationserhaltender Wellenleiter 36 zum Führen von Licht, der aus in den LiNbO$_3$-Kristall 35 eindiffundiertem Titan gebildet wird. Um den Wellenleiter 36 sind Elektroden $37_1$ bis $37_{16}$ angeordnet, die jeweils zu Elektrodenpaaren wirkungsmäßig zusammengefasst sind. Der Wellenleiter 36 verläuft zwischen den Elektroden $37_1$ bis $37_{16}$ der jeweiligen Elektrodenpaare. An jedem Elektrodenpaar kann über Elektrodenanschlüsse $38_1$ bis $38_9$ jeweils ein elektromagnetisches Feld angelegt werden durch Beaufschlagen der Elektrodenanschlüsse $38_1$ bis $38_9$ mit entsprechenden (voneinander unabhängigen) Spannungen bzw. Spannungswerten. Die Längen der Elektrodenpaare sind relativ zueinander binär abgestuft, d. h. mit Ausnahme des Elektrodenpaares, welches die geringste Länge aufweist, ist jedes Elektrodenpaar doppelt so lang wie ein anderes Elektrodenpaar. In einer weiteren Ausführungsform sind die Elektroden $37_1$ bis $37_8$ zu einer einzigen Elektrode zusammengefasst, so dass die Elektroden $37_9$ bis $37_{16}$ der zusammengefassten Elektrode gegenüberliegen. Weitere Anordnungen binär abgestufter Elektroden $37_1$ bis $37_{16}$ sind beispielsweise bekannt aus Veröffentlichung WO/9803895.

Die Elektroden $37_1$ bis $37_{16}$ haben vorzugsweise einen konstanten gegenseitigen Abstand von der optischen Achse des Wellenleiters.

Wird durch den zu messenden Strom zwischen orthogonalen, zirkular polarisierten Polarisationsmoden eine Phasenverschiebung erzeugt, so wird diese durch den Phasenmodulator 24 kompensiert. Aus der Größe des Rückstellsignals ist dann die Phasenverschiebung und damit der zu messende Strom ermittelbar. Die Kompensation wird erreicht durch Anlegen einzelner Spannungen an die Elektroden $37_1$ bis $37_{16}$, wodurch entsprechend der Feldstärken und Längen der dadurch erzeugten, binär abgestuften elektromagnetischen Felder die Polarisationsmoden, die die Felder durchlaufen, in ihren Phasen verschoben werden. Vorzugsweise ist eine Feldstärke der angelegten elektromagnetischen Felder umschaltbar zwischen einem festen Wert oder Null. Es ist jedoch auch denkbar, zusätzliche diskrete Zwischenwerte der Feldstärke zuzulassen, womit die Auflösung der Phasenmodulation weiter verfeinert werden könnte. Die Steuerung der Phasenverschiebung kann demnach über An- und Abschalten der einzelnen elektromagnetischen Felder erfolgen. Damit ist es möglich, trotz diskreter Feldstärken aufgrund mehrerer elektromagnetischer Felder die Phasenverschiebung "variabel" einzustellen: Durch Anlegen bzw. Abschalten entsprechender Spannungen an den einzelnen Elektrodenpaaren $37_1$ bis $37_{16}$ gibt es unter der Voraussetzung, dass die an die jeweiligen Elektrodenpaare $37_1$ bis $37_{16}$ anlegbare Spannung denselben Wert annimmt, aufgrund der acht Elektrodenpaare $37_1$ bis $37_{16}$ in dieser Ausführungsform 256 verschiedene Möglichkeiten, die Phasenverschiebung zwischen den beiden Licht-Teilstrahlen zu verändern. Damit ist auch bei direkter digitaler Ansteuerung des Phasenmodulators 24 eine gezielte Phasenmodulation mit feiner Auflösung möglich.

Die Phasenverschiebung wird vorzugsweise durch die mit den Elektroden $37_1$ bis $37_{16}$ des Phasenmodulators 24 verbundene Signalgeneratoreinheit 33 bewirkt, die digitale Modulations-Signale erzeugt, welche als Spannungen an die Elektroden $37_1$ bis $37_{16}$ des Phasenmodulators angelegt werden. Die Signalgeneratoreinheit 33 weist vorzugsweise einen Zufallsgenerator auf, mit dem die bereits erwähnten statistisch unabhängigen Modulations-Signalmuster erzeugbar sind.

Werden in dem Wellenleiter 36 zwei Licht-Teilstrahlen mit unterschiedlichen Polarisationsmoden geführt, so bestimmt sich eine zur Erzeugung einer Phasenverschiebung von π zwischen den jeweiligen Polarisationsmoden notwendige Spannung $U_\pi$ durch:

$$U_\pi = \frac{\lambda \cdot g}{\left(n_{TE}^3 r_{33} \Gamma_{TE} - n_{TM}^3 r_{13} \Gamma_{TM}\right) L}$$

wobei λ die Wellenlänge der geführten Lichtwelle ist, g einen Elektrodengap bezeichnet, $n_{TE,TM}$ effektive Brechungsindices für die beiden Polarisationsmoden im Wellenleiter 3 bezeichnen, $r_{13,33}$ elektrooptische Tensorkoeffizienten sind, und $\Gamma_{TE,TM}$ eine Feldüberlappung zwischen einem von Elektroden $37_1$ bis $37_{16}$ gebildeten elektrischen Feld und einem optischen Feld der geführten Licht-Teilstrahlen ist. L bezeichnet eine jeweilige Länge der Elektroden $37_1$ bis $37_{16}$.

Die Erfindung lässt sich auch auf Feldsensoren wie z. B. Spannungssensoren anwenden, die auf einer faseroptischen Einrichtung beruhen. Beispielsweise ist der in Patentanmeldung DE 100 44 197.1 gezeigte Phasenmodulator zur Rückstellung der durch eine zu messenden Spannung bewirkten Phasenverschiebung als digitaler Doppelbrechungs-Phasenschieber mit binär geteilten Elektroden ausführbar.

**Patentansprüche**

1. Verfahren zur Strommessung mittels eines faseroptischen In-Line-Sagnac-Interferometers (20), bei dem zwischen zwei orthogonalen Polarisationsmoden eines das Interferometer (20) durchsetzenden Lichtstrahis durch einen zu messenden Strom eine erste nichtreziproke Phasenverschiebung erzeugt wird. wobei zur Ermittlung der ersten Phasenverschiebung die Phasen der Polartsationsmoden unter Ausnutzung des Pockels-Effekts durch eine zweite nichtreziproke Phasenverschiebung zusätzlich geändert werden, derart, dass durch die zweite Phasenverschiebung eine Kompensation der ersten Phasenverschiebung bewirkt wird, **dadurch gekennzeichnet, dass** die zweite Phasenverschiebung durch eine Mehrzahl binär abgestufter elektromagnetischer Felder erfolgt, durch die die Polarisationsmoden geführt werden, und die zweite Phasenverschiebung eine Verschiebung der Kennlinie des Interferometers (20) in einen Bereich maximaler Linearität umfasst, wobei die Feldstärken der einzelnen elektromagnetischen Felder so variert werden, dass die Kennlinie des Interferometers (20) stochastisch unabhängig um +/-1,5 π oder um +/- 0,5 π in ihrer Phase verschoben wird.

2. Verfahren nach Anspruch 1, **dadurch gekennzeichnet, dass** die elektromagnetischen Felder direkt durch eine Mehrzahl parallel generierter, digitaler Spannungssignale erzeugt werden.

3. Einrichtung (20) zur Strommessung mittels eines faseroptischen In-Line-Sagnac-Interferometers, das einen Doppelbrechungs-Phasenmodulator (24) zur nichtreziproken Phasenmodulation zweier orthogonaler Polarisationsmoden eines das Interferometer durchsetzenden Lichtstrahls aufweist und als Closed-Loop-System ausgeführt ist, **dadurch gekennzeichnet, dass** der Doppelbrechungs-Phasenmodulator ein digitaler Doppelbrecliungs-Phasenmodulator (24) mit binär abgestuften Elektroden (371 bis 3716) ist. über den eine durch einen zu messenden Strom bewirkte Phasenverschiebung zwischen den Polarisationsmoden kompensierbar ist, wobei die Elektroden ($37_1$ bis $37_{16}$) von einem Zufallsgenerator ansteuerbar sind. der digitale Modulations-Signale zur statistisch unabhängigen Verschiebung der Interferometerkennlinie um +/- 1.5 π oder μm +/- 0.5 π in ihrer Phase erzeugt.

**Claims**

1. A method for current measurement by means of a fiber-optic in-line Sagnac interferometer (20), in which a first non-reciprocal phase shift is produced between two orthogonal polarization modes of a light beam, passing through the interferometer (20) by means of a current to be measured, in which case, in order to determine the first phase shift, the phases of the polarization modes are additionally changed by a second non-reciprocal phase shift, making use of Pockels effect, in such a way that the second phase shift compensates for the first phase shift, **characterized in that** the second phase shift is effected by a plurality of binary-gradated electromagnetic fields through which the polarization modes are passed, and the second phase shift comprises a shift of the characteristic curve of the interferometer (20) into a region of maximum linearity, the field strengths of the individual electromagnetic fields being varied such that the characteristic curve of the interferometer (20) is phase-shifted stochastically independently by +/- 1.5 $\pi$ or by +/- 0.5 $\pi$.

2. The method as claimed in claim 1, **characterized in that** the electromagnetic fields are generated directly by a plurality of digital voltage signals generated in parallel.

3. A device (20) for current measurement by means of a fiber-optic in-line Sagnac interferometer which has a birefringence phase modulator (24) for the non-reciprocal phase modulation of two orthogonal polarization modes of a light beam passing through the interferometer and is embodied as a closed-loop system, **characterized in that** the birefringence phase modulator is a digital birefringence phase modulator (24) with binary-gradated electrodes (371 to 3716), which can compensate for a phase shift between the polarization modes which is effected by a current to be measured, it being possible for the electrodes (371 to 3716) to be driven by a random generator which generates digital modulation signals for statistically independently phase-shifting the interferometer characteristic curve by +/- 1.5 $\pi$ or by +/- 0.5 $\pi$.

**Revendications**

1. Procédé de mesure de courant à l'aide d'un interféromètre de Sagnac en ligne à fibre optique (20), selon lequel un premier déphasage non réciproque est produit entre deux modes de polarisation orthogonaux d'un faisceau de lumière traversant l'interféromètre (20) par un courant à mesurer, et selon lequel pour la détermination du premier déphasage, les phases des modes de polarisation sont modifiées de façon supplémentaire moyennant l'utilisation de l'effet Pockels au moyen d'un second déphasage non réciproque, de telle sorte que sous l'effet du second déphasage, il se produit une compensation du premier déphasage, **caractérisé en**

**ce que** le second déphasage est réalisé à l'aide d'une multiplicité de champs électromagnétiques étagés de façon binaire, par lesquels les modes de polarisation sont guidés, et le second déphasage comprend un décalage de la courbe caractéristique de l'interféromètre (20) dans une gamme de linéarité maximale, les intensités des champs électromagnétiques individuels étant modifiées de telle sorte que la phase de la courbe caractéristique de l'interféromètre (20) est décalée, de façon indépendante stochastique, de +/- 1,5 x ou de +/- 0,5 $\pi$.

2. Procédé selon la revendication 1, **caractérisé en ce que** les champs électromagnétiques sont produits directement par une multiplicité de signaux de tension numériques, générés en parallèle.

3. Dispositif (20) pour la mesure de courant à l'intérieur d'un interféromètre Sagnac en ligne à fibre optique, qui comporte un modulateur de phase à biréfringence (24) pour la modulation de phase non réciproque de deux modes de polarisation orthogonaux d'un faisceau de lumière traversant l'interféromètre, et est réalisé sous la forme d'un système en boucle fermé, **caractérisé en ce que** le modulateur de phase à biréfringence est un modulateur de phase à biréfringence numérique (24) comportant des électrodes (371 à 3716), au moyen desquelles un déphasage, provoqué par un courant mesuré, entre les modes de polarisation peut être compensé, auquel cas les électrodes ($37_1$ à $37_{16}$) peuvent être commandées par un générateur de nombres aléatoires, qui produit des signaux de modulation numériques pour le décalage, indépendant de façon stochastique, de la courbe caractéristique de l'interféromètre et ce de +/- 1,5 $\pi$ ou de +/- 2,5 $\pi$.

FIG.1

EP 1 368 667 B1

FIG.2

FIG.3